# EUROPEAN PATENT APPLICATION

(11) **EP 1 833 106 A2**
(43) Date of publication of application: **12.09.2007**
(21) Application number: 07250972.2
(22) Date of filing: 08.03.2007
(51) Int. Cl.: H01L 51/52

(54) **Organic light emitting diode display device and method for fabricating the same**

(30) Priority: 08.03.2006 KR 20060021889; 19.07.2006 KR 20060067393
(71) Applicant: Samsung SDI Co., Ltd., Suwon-si, Gyeonggi-do (KR)
(72) Inventor: Song, Seung Yong, Legal & IP Team, Yongin-si Gyeonggi-do (KR); Lee, Kwan Hee, Legal & IP Team, Yongin-si Gyeonggi-do (KR)
(74) Representative: Mounteney, Simon James

(57) **Abstract**

Disclosed is an organic light emitting diode display capable of preventing a phenomenon of Newton's rings by maintaining a constant gap between a first substrate and a second substrate, and a method for fabricating the same. The organic light emitting diode display includes a first substrate including at least one pixel selected from the group consisting of a plurality of red, blue and green subpixels; and a second substrate arranged to be overlapped with the first substrate and having black matrixes respectively formed in positions corresponding to the subpixels and interfaces of the subpixels, wherein the organic light emitting diode display has a spacer between the first substrate and the second substrate.

## Description

### Field of the Invention

The present invention relates to an organic light emitting diode display and a method for fabricating the same, more specifically to an organic light emitting diode display capable of preventing a phenomenon of Newton's rings.

### Discussion of Related Art

In recent years, the organic light emitting diode display has been widely used in this field and has a relatively simple configuration. The organic light emitting diode display, also referred to as an organic light emitting diode device, is a self-emissive display using an organic film layer as an emission layer, and the organic light emitting diode display itself is thin and light-weight since it does not need an additional back light for emitting the light unlike a liquid crystal display. Accordingly, there have been many active attempts to develop organic light emitting diode displays as display panels of portable information terminals, including portable computers, cell phones, portable game apparatuses, electronic books, etc.

Some top emissive organic light emitting diode display have a structure having an emission layer interposed between a first electrode and a second electrode. Generally, a thin film transistor is formed on a substrate, and also a first electrode, electrically connected with the thin film transistor, is formed on the substrate. The first electrode functions as an anode for injecting a hole. An emission layer is formed on the first electrode, and a second electrode is formed on the emission layer. The second electrode functions as a cathode for injecting an electron. Also, the first electrode includes a reflective film having a high reflectivity, and the second electrode is formed of a transparent electrode.

Also, the organic light emitting diode display further includes an encapsulation substrate so that the organic light emitting diode device can be isolated from the outside environment to prevent moisture from being penetrated since a life span of the display may be shortened due to oxidation, peeling, etc. of electrode materials, and therefore a luminescence efficiency may be deteriorated if moisture and oxygen flow in from the neighboring environment. The encapsulation substrate has an edge in the outer region of the substrate.

However, the mentioned-above organic light emitting diode display includes a polarizer attached to a top surface of the encapsulation substrate so as to prevent a contrast of the organic light emitting diode device from being deteriorated by reflection of an external light since the contrast may be deteriorated when the external light reflects from a metallized material. However, the polarizer has disadvantages that its manufacturing cost is expensive and a luminescence efficiency may be deteriorated due to reduction of transmissivity of the light reflecting from the emission layer.

For this, a black matrix, patterned on a plurality of subpixels and encapsulation substrates corresponding to interfaces of the subpixels, is formed to function in place of the polarizer.

There has been proposed a method in which the organic light emitting diode display fabricated using the mentioned-above method is fabricated with a flat and thin glass encapsulation substrate by removing off an edge of the encapsulation substrate as the displays get slim.

However, such an encapsulation substrate droops from a central region, and therefore an optical interference phenomenon by the light generated from the light emitting diode display formed on the substrate is caused to form a concentrical pattern from a contact point of the encapsulation substrate if a gap between the substrate and the encapsulation substrate is formed very close to each other, or if the substrate or the encapsulation substrate attached to it is bent. An optical phenomenon where such a concentrical pattern is displayed in an image is called a Newton's ring, which distorts the image.

### SUMMARY

According to a first aspect of the invention, there is provided an organic light emitting display device as set out in claim 1. Optional features of this aspect are set out in claims 2 to 17.

According to a second aspect of the invention, there is provided a method of fabricating an organic light emitting display device as set out in claim 18. Optional features of this aspect are set out in claim 19.

Accordingly, an aspect of the present invention is designed to solve such above-mentioned drawbacks, and therefore an aspect of the present invention is to provide an organic light emitting diode display capable of preventing a phenomenon of Newton's rings by further forming a spacer between a first substrate and a second substrate having a black matrix formed therein, thereby to maintain a constant gap between the first substrate and the second substrate, and a method for fabricating the same.

In an embodiment of the present invention there is provided an organic light emitting diode display, including a first substrate including at least one pixel selected from the group consisting of a plurality of red, blue and green subpixels; and a second substrate arranged to be overlapped with the first substrate and having black matrixes respectively formed in positions corresponding to the subpixels and interfaces of the subpixels, wherein the organic light emitting diode display has a spacer between the first substrate and the second substrate.

In embodiments of the invention, the spacer may have a thickness of 3 to 12 µm, and the spacer may be a transparent polystyrene-based material. The spacer may be a spherical ball spacer, and the spacer may be composed of at least one material selected from the group consisting of organic materials and organic/inorganic mixtures.

In another embodiment of the present invention there is provided a method for fabricating an organic light emitting diode display, including steps of preparing a first substrate having at least one pixel selected from the group consisting of a plurality of red, blue and green subpixels; distributing a spacer on the first substrate; arranging a second substrate arranged to be overlapped with the first substrate and having black matrixes respectively formed in positions corresponding to the subpixels and interfaces of the subpixels; coating the outermost region of the second substrate with an adhesive member; and attaching the first substrate to the second substrate by means of the adhesive member, followed by curing the adhesive member.

In a further embodiment of the present invention there is provided a method for fabricating an organic light emitting diode display, including steps of preparing a first substrate having at least one pixel selected from the group consisting of a plurality of red, blue and green subpixels; arranging a second substrate arranged to be overlapped with the first substrate and having black matrixes respectively formed in positions corresponding to the subpixels and interfaces of the subpixels; forming a spacer on the black matrix; coating the outermost region of the first substrate with a sealant; and attaching the first substrate to the second substrate by means of the sealant, followed by curing the sealant.

### BRIEF DESCRIPTION OF THE DRAWINGS

These and/or other aspects and advantages of the invention will become apparent and more readily appreciated from the following description of the preferred embodiments, taken in conjunction with the accompanying drawings of which:

FIG. 1 is a cross-sectional view showing an organic light emitting diode display according to a first embodiment of the present invention.

FIGs. 2A to 2D are cross-sectional views showing a method for fabricating the organic light emitting diode display according to the first embodiment of the present invention.

FIG. 3 is a cross-sectional view showing an organic light emitting diode display according to a second embodiment of the present invention.

FIGs. 4A to 4D are cross-sectional views showing a method for fabricating the organic light emitting diode display according to the second embodiment of the present invention.

FIG. 5 is a cross-sectional view showing an organic light emitting diode display according to a third embodiment of the present invention.

FIG. 6 is a cross-sectional view showing an organic light emitting diode display according to a fourth embodiment of the present invention.

### DETAILED DESCRIPTION OF EMBODIMENTS

Hereinafter, embodiments according to the present invention will be described with reference to the accompanying drawings. Here, when one element is connected to another element, one element may be not only directly connected to another element but also indirectly connected to another element via another element. Further, irrelative elements are omitted for clarity. Also, like reference numerals refer to like elements throughout.

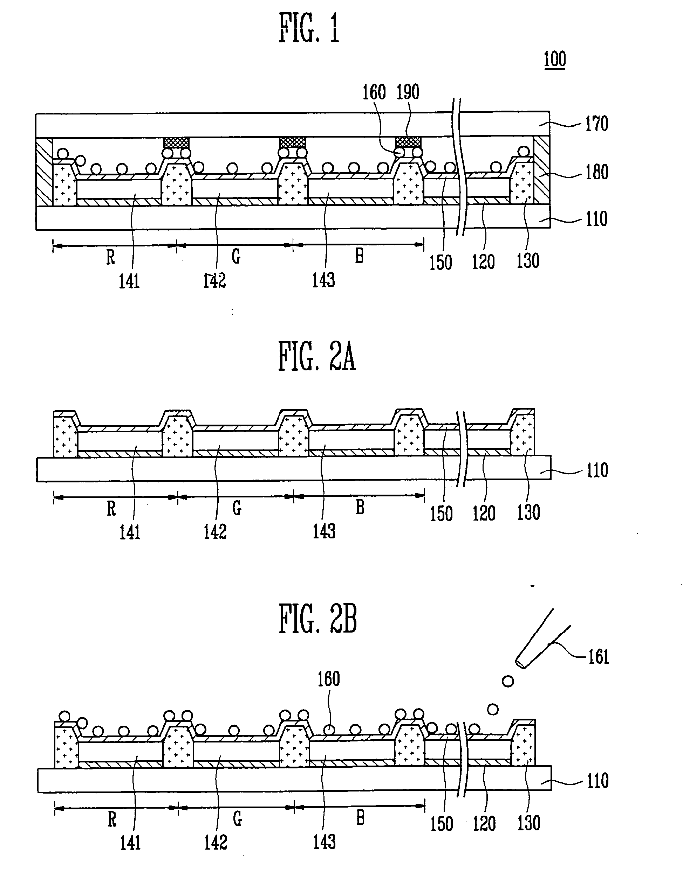

FIG. 1 is a cross-sectional view showing an organic light emitting diode display according to a first embodiment of the present invention.

Referring to FIG. 1, the organic light emitting diode display 100 includes a first substrate 110 including at least one pixel selected from the group consisting of a plurality of red (R), green (G) and blue (B) subpixels; and a second substrate 170 arranged to be overlapped with the first substrate 110 and having black matrix 190 respectively formed in positions corresponding to the subpixels and interfaces of the subpixels, wherein the organic light emitting diode display 100 has a spacer 160 between the first substrate 110 and the second substrate 170.

On the first substrate 110 is formed a plurality of pixels selected from the group consisting of red (R), green (G) and blue (B) subpixels. Each of the subpixels (R,G,B) includes a thin film transistor and an organic light emitting diode device. The organic light emitting diode device includes a first electrode, an emission layer and a second electrode. For convenience's sake of description, a detailed disclosure and specific description of a thin film transistor are omitted. The first substrate 110 is made of insulating materials such as glass, plastic, silicon or synthetic resin, and is preferably a glass substrate.

A first electrode 120 is patterned on the first substrate 110 having subpixel regions of the red (R), green (G) and blue (B) colors, respectively. The first electrode 120 is made of conductive metal compounds such as, but not limited to, aluminum (Al), aluminum alloy, silver (Ag), silver alloy, MoW, molybden (Mo), copper (Cu) or ITO, IZO and like. However, an embodiment of the present invention relates to a top emissive organic light emitting diode display 100 in which a reflector layer is further formed on at least one surface of the first electrode 120.

The pixel definition layer 130 is formed on the first electrode 120, and an opening for at least partially exposing the first electrode 120 is formed on the pixel definition layer 130. The pixel definition layer 130 defines each pixel formed on the first electrode 120.

A red emission layer 141, a green emission layer 142 and a blue emission layer 143 corresponding to each pixel region are patterned on the first electrode 120. The red emission layer 141, the green emission layer 142 and the blue emission layer 143 may further include some of a hole injection layer, a hole transport layer, an electron transport layer and an electron injection layer. The red emission layer 141, the green emission layer 142 and the blue emission layer 143 generate the lights by binding together holes and electrons injected from the first electrode 120 and a second electrode 150.

The second electrodes 150 are formed on the pixel definition layer 130, the red emission layer 141, the green emission layer 142 and the blue emission layer 143. The second electrode 150 is preferably formed of one material out of transparent ITO, IZO and ZnO.

Meanwhile, the spacer 160 is distributed on the second electrode 150. The spacer 160 is formed of a transparent polystyrene-based material, which transmits the lights generated in the red emission layer 141, the green emission layer 142 and the blue emission layer 143, and is formed into a spherical ball spacer. Also, in this particular embodiment, the sum of thicknesses of the spacer 160 and the black matrix 190 accounts for at least 6 µm. This prevents a phenomenon of Newton's rings since the phenomenon of Newton's rings is commonly generated if the gap between the first substrate 110 and the second substrate 170 is 5 µm or less. Also, the spacer 160 has a thickness, namely a diameter of preferably 3 to 12µm. Also, if a protective layer is further formed on the second electrode 150, the spacer 160 can be distributed on the protective layer.

The spacer 160 maintains a constant gap between the first substrate 110 and the second substrate 170. That is to say, the spacer 160, distributed on the second electrode 150 formed on the pixel definition layer 130, is in direct contact with the black matrix 190, formed in a lower surface of the second substrate 170, thereby to prevent the second substrate 170 from being in direct contact with the first substrate 110. Accordingly, a phenomenon of Newton's rings, generated as the second substrate 170 droops, may be prevented by maintaining a constant gap between the first substrate 110 and the second substrate 170.

The second substrate 170 is formed on the first substrate 110 to prevent the red emission layer 141, the green emission layer 142 and the blue emission layer 143 from being exposed to oxygen or moisture from the outside environment. The first substrate 110 is in contact with the second substrate 170 by means of an adhesive member 180 coated along a circumferential direction of the second substrate 170. The adhesive member 180 may be formed of a sealant or a frit. The frit may be formed of one selected from the group consisting of K₂O, Fe₂O₃, Sb₂O₃, ZnO, P₂O₅, V₂O₅, TiO₂, Al₂O₃, B₂O₃, WO₃, SnO and PbO.

The second substrate 170 is formed of a flat and thin glass. A transparent substrate transmitting the lights generated in the red emission layer 141, the green emission layer 142 and the blue emission layer 143 is preferably used as the second substrate 170. Also the second substrate 170 may be formed into a thin glass substrate provided with a color filter. In this case, an emission layer is formed with a single color, and the color filter converts the lights, emitted from the emission layers (141,142,143), into predetermined colors.

Also, the black matrixes 190 having a predetermined pattern are formed in lower surfaces of the second substrates 170, namely lower surfaces of the second substrates 170 corresponding to the subpixels (R,G,B) and interfaces of the subpixels (R,G,B). The black matrix 190 makes each color of the subpixels (R,G,B) vivid by shielding the lights emitted from the red, green and blue emission layers (141,142,143) in every subpixels (R,G,B), and makes an image vivid by minimizing reflectivity of the lights incident from the outside environment. Organic polymeric resins having a low photoreflectivity, or metal materials such as chromium (Cr) and molybdenum (Mo) are preferably used for the black matrix 190.

FIGs. 2A to 2D are cross-sectional views showing a method for fabricating the organic light emitting diode display according to the first embodiment of the present invention.

Referring to FIG. 2A, a first substrate 110 is prepared for the first time to fabricate the organic light emitting diode display 100. On the first substrate 110 is formed a plurality of pixels selected from the group consisting of subpixels of red (R), green (G) and blue (B) colors. On the first substrate 110 are formed a thin film transistor and an organic light emitting diode device corresponding to each of the subpixels. The organic light emitting diode device includes a first electrode, an emission layer and a second electrode. On the first substrate 110 are formed first electrodes 120 corresponding to subpixel regions of the red (R), green (G) and blue (B) colors. A pixel definition layer 130 is formed on the first electrode 120, and includes an opening for exposing at least one region of the first electrode 110. On the first electrode 110 are patterned the red emission layer 141, the green emission layer 142 and the blue emission layer 143 corresponding to each of the subpixels (R,G,B). The red emission layer 141, the green emission layer 142 and the blue emission layer 143 may be made of a single-layer film or a plurality of multi-layer films selected from the group consisting of a hole injection layer, a hole transport layer, an emission layer, a hole inhibition layer, an electron transport layer and an electron injection layer. The second electrodes 150 are deposited on top surfaces of the pixel definition layer 130, the red emission layer 141, the green emission layer 142 and the blue emission layer 143.

Referring to FIG. 2B, a spacer 160 is distributed on the second electrode 150 of the first substrate 110. The spacer 160 is distributed on the first substrate 110 using an automatic spacer dispenser 161. Also, the spacer 160 is in the form of a transparent polystyrene-based ball spacer, and the spacer 160 preferably has a diameter of 3 to 12 µm.

Referring to FIG. 2C, a black matrix 190 having a predetermined pattern is formed on a lower surface of the second substrate 170 in positions corresponding to the subpixels (R,G,B) and interfaces of the subpixels (R,G,B). That is to say, the black matrix 190 is formed on the second substrate 170 corresponding to pixel definition layer 130 for defining pixels among the red emission layer 141, the green emission layer 142 and the blue emission layer 143. The black matrix 190 is patterned into a predetermined shape by coating the lower surface of the second substrate 170 with at least one metal material selected from the groups consisting of organic polymeric resins having a low photoreflectivity, chromium (Cr) and molybden (Mo), followed by undergoing exposure and development processes using a photomask, etc. However, a height and a width of the black matrix 190 are limited to the range where the red, green and blue colors (141,142,143) are not deteriorated. Also, an adhesive member 180 is coated at a predetermined thickness along a circumferential direction of the second substrate 170, namely along the outermost region of the second substrate 170 so as to seal the first substrate 110 and the second substrate 170.

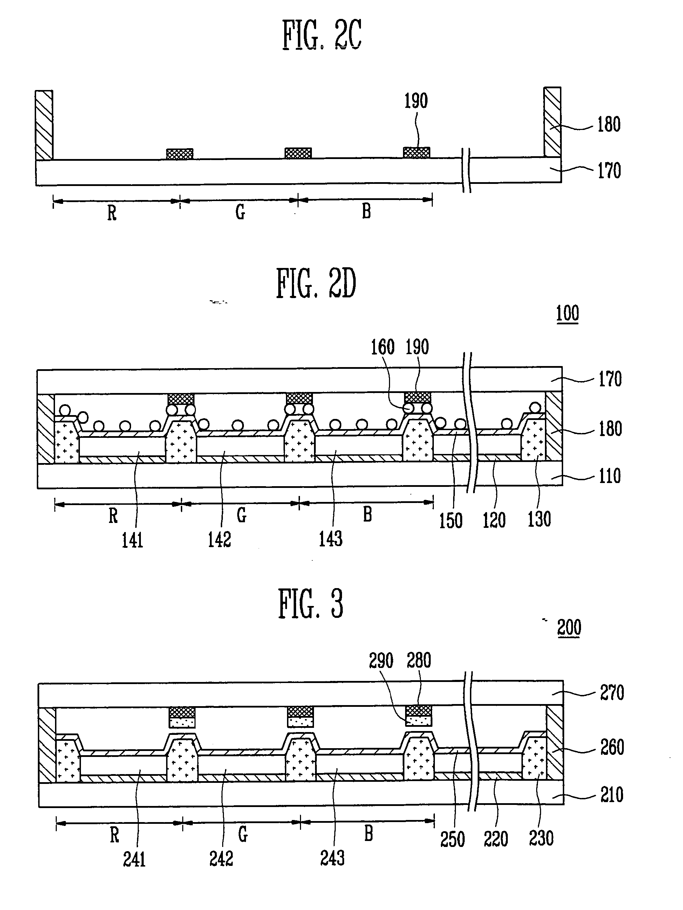

Referring to FIG. 2D, the second substrate 170, coated with the adhesive member 180, is in contact with the first substrate 110. At this time, the black matrix 190, formed in the lower surface of the second substrate 170, is arranged to face against the first substrate 110. Then, an organic light emitting diode device, formed on the first substrate 110, is protected from moisture or oxygen by curing the adhesive member 180 using an ultraviolet ray (UV), a laser, an infrared ray or the like.

FIG. 3 is a cross-sectional view showing an organic light emitting diode display according to a second embodiment of the present invention.

In order to avoid an overlapped description, detailed descriptions of the same components as in the mentioned-above first embodiment, for example a first substrate 110, a first electrode 120, a second electrode 150 and a black matrix 190 are omitted.

Referring to FIG. 3, the organic light emitting diode display 200 includes a first substrate 210 including at least one pixel selected from the group consisting of a plurality of red (R), green (G) and blue (B) subpixels; and a second substrate 270 arranged to be overlapped with the first substrate 210 and having black matrix 280 respectively formed in positions corresponding to the subpixels and interfaces of the subpixels, wherein a spacer 290 is formed on the black matrix 280.

The first electrode 220 is patterned on the first substrate 210 having subpixel regions of the red (R), green (G) and blue (B) colors, respectively.

The pixel definition layer 230 is formed on the first electrode 220, and an opening for at least partially exposing the first electrode 220 is formed on the pixel definition layer 230.

On the first electrode 220 are patterned the red emission layer 241, the green emission layer 242 and the blue emission layer 243 corresponding to each pixel region. The red emission layer 241, the green emission layer 242 and the blue emission layer 243 generate the lights by binding together holes and electrons injected from the first electrode 220 and a second electrode 250.

The second electrode 250 is formed on top surfaces of the pixel definition layer 230, the red emission layer 241, the green emission layer 242 and the blue emission layer 243.

Meanwhile, the spacer 290 is formed on the black matrix 280. The spacer 290 maintains a constant gap between the first substrate 210 and the second substrate 270. The spacer 290 prevents the second substrate 270 and the black matrix 280 from being in direct contact with the first substrate 210. Accordingly, a phenomenon of Newton's rings, caused when the second substrate 270 droops, may be prevented by maintaining a constant gap between the first substrate 210 and the second substrate 270. The spacer 290 is preferably composed of at least one material selected from the group consisting of organic materials and organic/inorganic mixtures. Also, the sum of thicknesses of the spacer 290 and the black matrix 280 preferably accounts for at least 6 µm. At this time, the spacer 290 has a thickness of preferably 3 to 12 µm. This prevents a phenomenon of Newton's rings since the phenomenon of Newton's rings is commonly generated if the gap between the first substrate 210 and the second substrate 270 is 5 µm or less.

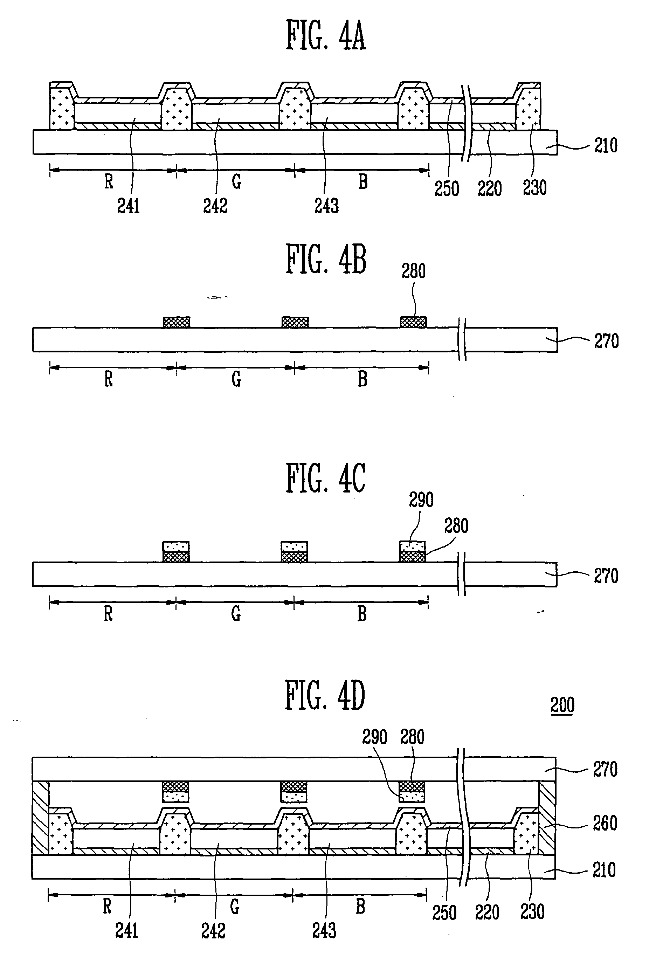

FIGs. 4A to 4D are cross-sectional views showing a method for fabricating the organic light emitting diode display according to the second embodiment of the present invention.

Referring to FIG. 4A, a first substrate 210 is firstly prepared to fabricate the organic light emitting diode display 200. On the first substrate 210 are formed a plurality of pixels selected from the group consisting of red (R), green (G) and blue (B) subpixels. The subpixels (R,G,B) have a thin film transistor and an organic light emitting diode device formed in the first substrate 210, the thin film transistor and the organic light emitting diode device corresponding to each of the subpixels. The organic light emitting diode device includes a first electrode, an emission layer and a second electrode. On the first substrate 210 are formed first electrodes 220 corresponding to subpixel regions of the red (R), green (G) and blue (B) colors. A pixel definition layer 230 is formed on the first electrode 220, and includes an opening for exposing at least one region of the first electrode 220. On the first electrode 220 are patterned the red emission layer 241, the green emission layer 242 and the blue emission layer 243 corresponding to each of the subpixels (R,G,B). The red emission layer 241, the green emission layer 242 and the blue emission layer 243 may be made of a single-layer film or a plurality of multi-layer films selected from the group consisting of a hole injection layer, a hole transport layer, an emission layer, a hole inhibition layer, an electron transport layer and an electron injection layer. The second electrodes 250 are deposited on top surfaces of the pixel definition layer 230, the red emission layer 241, the green emission layer 242 and the blue emission layer 243.

Referring to FIG. 4B, the second substrate 270 is prepared to seal the first substrate 210. The black matrixes 280 having a predetermined pattern are formed in positions corresponding to the subpixels (R,G,B) and interfaces of the subpixels (R,G,B) on a lower surface of the second substrate 270. That is to say, the black matrix 280 is formed on the second substrate 270 corresponding to pixel definition layer 230 for defining pixels among the red emission layer 241, the green emission layer 242 and the blue emission layer 243. The black matrix 280 is patterned into a predetermined shape by coating the lower surface of the second substrate 270 with at least one material selected from the groups consisting of organic polymeric resins having a low photoreflectivity, chromium (Cr) and molybden (Mo), followed by undergoing exposure and development processes using a photomask, etc. However, a height and a width of the black matrix 280 are limited to the range where colors of the red, green and blue (241,242,243) emission layers are not deteriorated.

Referring to FIG. 4C, a spacer 290 is formed on the black matrix 280. The spacer 290 is at least one material selected from the group consisting of organic materials and organic/inorganic mixtures, and preferably has a height of 3 to 12 µm and corresponds to a width of the black matrix 280. Also, the sum of thicknesses of the black matrix 280 and the spacer 290 preferably accounts for at least 6 µm.

Referring to FIG. 4D, a sealant 260 is coated at a predetermined thickness along a circumferential direction of the first substrate 210, namely along the outermost region of the first substrate 210 so as to seal the first substrate 210 and the second substrate 270. The second substrate 270 is in contact with the first substrate 210 coated with the sealant 260. At this time, the spacer 290, formed in the lower surface of the second substrate 270, is arranged to face against the first substrate 210. Then, the first substrate 210 and the second substrate 270 are completely sealed by curing the sealant 260 using a UV-ray or the like.

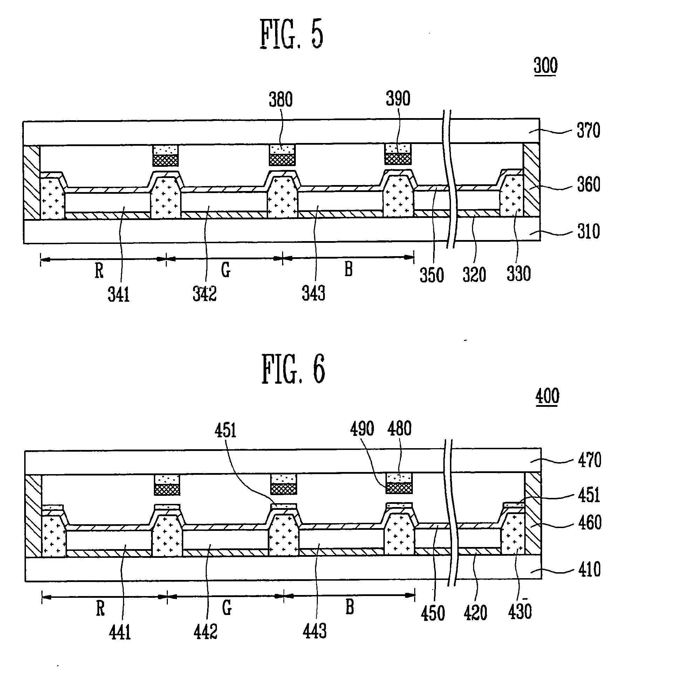

FIG. 5 is a cross-sectional view showing an organic light emitting diode display according to a third embodiment of the present invention.

In order to avoid an overlapped description, detailed descriptions of the same components as in the mentioned-above first embodiment, for example a first substrate 110, a first electrode 120, a second electrode 150 and a black matrix 190 are omitted.

Referring to FIG. 5, the organic light emitting diode display 300 includes a first substrate 310 including at least one pixel selected from the group consisting of a plurality of red (R), green (G) and blue (B) subpixels; a spacer 380 arranged to be overlapped with the first substrate 310 and respectively formed with a predetermined pattern in positions corresponding to the subpixels and interfaces of the subpixels on a lower surface of the second substrate 370; and a black matrix 390 formed on the spacer 380.

On the first substrate 310 are formed a plurality of pixels selected from the group consisting of the red (R), green (G) and blue (B) subpixels. Generally, the subpixels have a thin film transistor and an organic light emitting diode device formed on the first substrate 310. The organic light emitting diode device includes a first electrode, an emission layer and a second electrode.

The first electrode 320 is patterned on the first substrate 310 having subpixel regions of the red (R), green (G) and blue (B) colors.

The pixel definition layer 330 is formed on the first electrode 320, and an opening for at least partially exposing the first electrode 320 is formed on the pixel definition layer 330.

The red emission layer 341, the green emission layer 342 and the blue emission layer 343 corresponding to each of the pixel regions are patterned on the first electrode 320. The red emission layer 341, the green emission layer 342 and the blue emission layer 343 generate the lights by binding together holes and electrons injected from the first electrode 320 and the second electrode 350.

The second electrodes 350 are formed on top surfaces of the pixel definition layer 330, the red emission layer 341, the green emission layer 342 and the blue emission layer 343.

The second substrate 370 is formed on the first substrate 310 to prevent the red emission layer 341, the green emission layer 342 and the blue emission layer 343 from being exposed to the outside environment. The second substrate 370 is in contact with the first substrate 310 by means of the sealant 360 coated along a circumferential direction of the first substrate 310.

Meanwhile, the spacer 380 is formed with a predetermined pattern on a lower surface of the second substrate 370, namely on a lower surface of the second substrate 370 corresponding to the subpixels (R,G,B) and interfaces of the subpixels (R,G,B). The spacer 380 is formed into a predetermined pattern by coating the lower surface of the second substrate 370 with one material selected from the groups consisting of organic materials and organic/inorganic mixtures, followed by undergoing exposure and development processes. The spacer 380 maintains a constant gap between the first substrate 310 and the second substrate 370. The spacer 380 prevents the second substrate 370 from being in direct contact with the first substrate 310. Accordingly, a phenomenon of Newton's rings, generated as the second substrate 370 droops, is prevented. The spacer 380 is composed of at least one material selected from the group consisting of organic materials and organic/inorganic mixtures. Also, the sum of thicknesses of the spacer 380 and the black matrix 390 preferably accounts for at least 6 µm. This prevents a phenomenon of Newton's rings since the phenomenon of Newton's rings is commonly generated if the gap between the first substrate 310 and the second substrate 370 is 5 µm or less. At this time, the spacer 380 has a thickness of preferably 3 to 12 µm.

The black matrix 390 is formed on the second spacer 380. The black matrix 390 makes each color of the subpixels (R,G,B) vivid by shielding the lights, emitted from the red, green and blue emission layers (341,342,343), in every subpixels (R,G,B), and makes an image vivid by minimizing reflectivity of the lights incident from the outside environment. Organic polymeric resins having a low photoreflectivity, or metal materials such as chromium (Cr) and molybden (Mo) are used for the black matrix 390.

FIG. 6 is a cross-sectional view showing an organic light emitting diode display according to a fourth embodiment of the present invention.

In order to avoid an overlapped description, detailed descriptions of the same components as in the mentioned-above first embodiment, for example a first substrate 110, a first electrode 120, a second electrode 150 and a black matrix 190 are omitted.

Referring to FIG. 6, the organic light emitting diode display 400 includes a first substrate 410 including at least one pixel selected from the group consisting of a plurality of red (R), green (G) and blue (B) subpixels and a first spacer 451 formed on the subpixel and an interface of the subpixel; a second spacer 480 arranged to be overlapped with the first substrate 410 and respectively formed with a predetermined pattern in a position corresponding to the spacer 451 on a lower surface of the second substrate 470; and a black matrix 490 formed on the second spacer 480.

The first electrode 420 is patterned on the first substrate 410 having subpixel regions of the red (R), green (G) and blue (B) colors.

The pixel definition layer 430 is formed on the first electrode 420, and an opening for at least partially exposing the first electrode 420 is formed on the pixel definition layer 430.

The red emission layer 441, the green emission layer 442 and the blue emission layer 443 corresponding to each of the pixel regions are patterned on the first electrode 420. The red emission layer 441, the green emission layer 442 and the blue emission layer 443 generate the lights by binding together holes and electrons injected from the first electrode 420 and the second electrode 450.

The second electrodes 450 are formed on top surfaces of the pixel definition layer 430, the red emission layer 441, the green emission layer 442 and the blue emission layer 443.

Meanwhile, the first spacers 451 are formed with a predetermined pattern on the subpixels (R,G,B) and interfaces of the subpixels (R,G,B), namely on the second electrode 450 having the pixel definition layer 430 formed therein. The first spacer 451 is formed into a predetermined pattern by coating the upper surface of the second electrode 450 with one material selected from the groups consisting of organic materials and organic/inorganic mixtures, followed by undergoing exposure and development processes. The first spacer 451 preferably has a thickness of 1 to 5 µm. The most preferably, the first spacer 451 has a thickness of 1.2 µm. The first spacer 451 desirably has a thickness as thin as possible, because it is difficult to form a thick first spacer 451 in the process itself since the first spacer 451 is composed of organic materials and organic/inorganic mixtures. As described above, the first spacer 451 maintains a constant gap between the first substrate 410 and the second substrate 470 in addition to the black matrix 490 and the second spacer 480 and prevents drooping of the second substrate 470.

The second substrate 470 is formed on the first substrate 410 so as to prevent the red emission layer 441, the green emission layer 442 and the blue emission layer 443 from being exposed to the outside environment. The second substrate 470 is in contact with the first substrate 410 by means of the sealant 460 coated along a circumferential direction of the first substrate 410.

Meanwhile, the second spacers 480 are formed with a predetermined pattern on a lower surface of the second electrode 470, namely on a lower surface of the second substrate 470 corresponding to the first spacer 451. The second spacer 480 is formed into a predetermined pattern by coating the lower surface of the second substrate 470 with one material selected from the groups consisting of organic materials and organic/inorganic mixtures, followed by undergoing exposure and development processes. The second spacer 480 maintains a constant gap between the first substrate 410 and the second substrate 470 in addition to the first spacer 451 and the black matrix 490. The second spacer 480, the first spacer 451 and the black matrix 490 prevent the second substrate 470 from being in direct contact with the first substrate 410. Accordingly, a phenomenon of Newton's rings, generated as the second substrate 470 droops, is prevented. The sum of thicknesses of the second spacer 480 and the black matrix 490 preferably accounts for at least 5 µm. At this time, the second spacer 480 has a thickness of preferably 3 to 12 µm. Also, the phenomenon of Newton's rings is commonly prevented if the gap between the first substrate 410 and the second substrate 470 accounts for at least 6 µm, and therefore a thickness of the second spacer 480 and the black matrix 490 is set to at least 5 µm if the first spacer 451 has a thickness of 1 µm. That is to say, the phenomenon of Newton's rings is commonly prevented if the gap between the first substrate 410 and the second substrate 470 accounts for at least 6 µm, and therefore the sum of thicknesses of the first spacer 451, the black matrix 490 and the second spacer 480 preferably accounts for at least 6 µm.

Accordingly, the phenomenon of Newton's rings is prevented as the second substrate 470 droops, and the gap between the first substrate 410 and the second substrate 470 is maintained at a length of at least 6 µm to prevent the phenomenon of Newton's rings.

The black matrix 490 is formed on the second spacer 480. The black matrix 490 makes each color of the subpixels (R,G,B) vivid by shielding the lights emitted from the red, green and blue emission layers (441,442,443), in every subpixels (R,G,B), and makes an image vivid by minimizing reflectivity of the lights incident from the outside environment. Organic polymeric resins having a low photoreflectivity, or metal materials such as chromium (Cr) and molybden (Mo) are preferably used for the black matrix 490. For convenience's sake of description, it goes without saying that the black matrix 490 is formed on the second spacer 480, but a position on which the second spacer 480 and the black matrix 490 are formed may be changed herein.

As described above, according to embodiments of the present invention, a second substrate is prevented from being in direct contact with a first substrate by further forming a spacer between the first substrate and the second substrate on which a black matrix is formed, thereby to maintain a constant gap between the first substrate and the second substrate. Accordingly, a drooping phenomenon of the second substrate is prevented, and therefore a phenomenon of Newton's rings generated in the display, namely a concentrical pattern appearing on a screen is inhibited.

Although a few embodiments of the present invention have been shown and described, it will be appreciated by those skilled in the art that changes might be made in the embodiments without departing from the principles of the invention, the scope of which is defined in the claims and their equivalents.

## Claims

1. An organic light emitting display device comprising:
a first substrate;
a second substrate comprising a display surface configured to display an image therethrough;
an array of organic light emitting pixels provided between the first substrate and the second substrate;
a black matrix provided between the array and the second substrate; and
at least one spacer provided between the array and the second substrate,
wherein the at least one spacer is arranged to keep the second substrate and the array spaced apart from each other.

2. A device according to Claim 1, wherein the black matrix and the at least one spacer in combination are arranged to keep the second substrate and the array spaced apart from each other.

3. A device according to either preceding claim wherein at least part of the at least one spacer is aligned with the black matrix along a direction generally perpendicular to the display surface.

4. A device according to any preceding claim, wherein at least part of the at least one spacer is fixed to the black matrix or the array.

5. A device according to any preceding claim, wherein the array comprises a plurality of emissive surfaces for emitting visible light and a plurality of non-emissive surfaces for partitioning the plurality of emissive surfaces, wherein each emissive surface and the second substrate forms a gap therebetween..

6. A device according to Claim 5, wherein the gap to the display surface of the second substrate from one of the emissive surfaces generally in the center of the array is substantially the same as the gap to the display surface of the second substrate from one of the emissive surfaces away from the center of the array.

7. A device according to Claim 6 or 6, wherein each gap is at least about 6 µm.

8. A device according to any preceding claim, wherein the at least one spacer has a height in a direction perpendicular to the display surface of about 3µm to about 12 µm.

9. A device according to any preceding claim, wherein at least part of the at least one spacer is substantially transparent.

10. A device according to any preceding claim, wherein the array comprises a plurality of emissive surfaces for emitting visible light and a plurality of non-emissive surfaces for partitioning the plurality of emissive surfaces, and wherein the black matrix is aligned with at least part of the non-emissive surfaces such that the black matrix does not substantially block visible light from the emissive surface.

11. A device according to any preceding claim, wherein the at least one spacer is provided between the black matrix and the second substrate.

12. A device according to any preceding claim, wherein a plurality of spacers are provided in the form of beads.

13. A device according to any one of Claims 1 to 11, wherein a plurality of spacers are provided in the form of stripes generally aligned with the black matrix.

14. A device according to any preceding claim, wherein the array comprises a plurality of emissive surfaces for emitting visible light and a plurality of non-emissive surfaces for partitioning the plurality of emissive surfaces, wherein at least part of the at least one spacer contacts at least one of the emissive and non-emissive surfaces.

15. A device according to Claim 14, wherein the black matrix is generally aligned with the non-emissive surfaces such that visible light from the emissive surface can pass through openings defined by the black matrix, and wherein at least part of the at least one spacer is provided between the black matrix and at least part of the non-emissive surfaces.

16. A device according to Claim 15, wherein the non-emissive surfaces comprise a bump portion which is closer to the second substrate than a non-bump portion, and wherein at least part of the at least one spacer is provided between the black matrix and the bump portion of the non-emissive surface.

17. A device according to Claim 1, wherein the black matrix is formed on the second substrate.

18. A device according to Claim 1, wherein the black matrix comprises a plurality of stripes defining a plurality of openings between two neighboring stripes, and wherein a plurality of spacers are provided and at least part of the plurality of spacers are stripes aligned with at least part of the black matrix stripes.

19. A method for fabricating an organic light emitting display device comprising:
providing a first plate comprising a first substrate and an array of organic light emitting pixels;
providing a second plate comprising a second substrate and a black matrix formed on the second substrate;
aligning the first plate and the second plate such that the black matrix and the array are interposed between the first and second substrates;
providing the at least one spacer between the array and the second substrate such that the at least one spacer is arranged to keep the second substrate and the array spaced apart from each other; and
integrating the first plate with the second plate using an adhesive member.

20. A method according to Claim 19, wherein the black matrix and the at least one spacer in combination are arranged to keep the second substrate and the array spaced apart from each other.
